# EUROPEAN PATENT SPECIFICATION

(11) **EP 4 355 037 B1**
(45) Date of publication and mention of the grant of the patent: **04.03.2026**
(21) Application number: 23202707.8
(22) Date of filing: 10.10.2023
(51) Int. Cl.: H05K 1/03, A41D 1/00, H05K 3/28, H05K 3/30

(54) **A METHOD OF ELECTRICALLY CONTACTING AND ENCAPSULATING AN ELECTRONIC COMPONENT ON A TEXTILE SUBSTRATE OF A SMART TEXTILE, A HOUSING FOR CARRYING OUT THE INVENTED METHOD, AND A HOUSING AND TEXTILE SUBSTRATE ASSEMBLY FORMED BY MEANS OF THE INVENTION**
VERFAHREN ZUM ELEKTRISCHEN KONTAKTIEREN UND VERKAPSELN EINES ELEKTRONISCHEN BAUTEILS AUF EINEM TEXTIL
PROCÉDÉ DE MISE EN CONTACT ÉLECTRIQUE ET D'ENCAPSULATION D'UN COMPOSANT ÉLECTRONIQUE SUR UN SUBSTRAT TEXTILE

(30) Priority: 12.10.2022 CZ 20224310; 12.10.2022 CZ 202240335 U
(43) Date of publication of application: 17.04.2024
(73) Proprietor: Západoceská univerzita v Plzni, 301 00 Plzen (CZ)
(72) Inventor: Moravcova, Daniela, Mysliv (CZ); Janda, Martin, Plzen (CZ); Sima, Karel, Plzen (CZ); Kadlec, Petr, Plzen (CZ); Kalas, David, Rokycany (CZ); Soukup, Radek, Plzen (CZ); Reboun, Jan, Rokycany (CZ); Hamacek, Ales, Chotesov (CZ)
(74) Representative: Sedlák, Jirí

(56) References cited:
- EP-A1- 3 784 007
- KALAS DAVID ET AL: "Stretch Testing of SMD Resistors Contacted by a Novel Thermo-compression Method on a Textile Ribbon", 2021 44TH INTERNATIONAL SPRING SEMINAR ON ELECTRONICS TECHNOLOGY (ISSE), IEEE, 5 May 2021 (2021-05-05), pages 1 - 5, XP033936834, DOI: 10.1109/ISSE51996.2021.9467635

## Description

### Field of the Invention

The invention relates to a method of electrically contacting and encapsulating electronic components or electronic modules (hereinafter referred to as electronic components) on textile substrates of smart textiles, in which electrical interconnection of these electronic components with electrically conductive tracks of the textile substrate is realized. The invention also includes a housing for creating electrical contacting and encapsulating of electronic components, and an assembly comprising a housing and a textile substrate.

### Background of the Invention

For the production of smart textiles, there are currently techniques for integrating planar electronic elements such as temperature, humidity and pressure sensors, antennas or heating onto textile substrates. Integration is done by printing conductive pastes and inks, or by embroidering and knitting using conductive threads. Such electronic elements are flexible, allow spatial storage, often copy even very complex shapes, do not affect and limit the user comfort. However, in the field of smart textiles, there often has to be an electrical connection with an external evaluation and communication unit, as there is no method of implementing integrated circuits directly on textile substrates.

Therefore, the weakest part of smart textiles is not the functional and interconnection structures themselves, but the interconnection of these structures with conventional electronic components or with superior electronics for evaluation, wireless communication or actuator control. It is at the point of connection of the textile substrate with the rigid component or printed circuit that the most defects occur.

One of the well-known methods of electrical contacting of electronic components (SMD - surface mount devices) or electronic modules is based on the production of common printed circuit boards, namely soldering. For example, the invention in application US 2005 029 680 (A1) and the invention in application EP 3 057 384 (A1) deal with this method of contact. This contacting technique is reliable, inexpensive and excels in low electrical resistance. On the other hand, it hides drawbacks in the form of the need for a temperature-resistant substrate, which textile substrates usually are not.

Furthermore, a person skilled in the art may encounter technologies of ultrasonic or resistance welding, embroidering, etc. These methods of electrical contacting excel in low electrical resistance (ultrasonic and resistance welding) and proven method of production (embroidery). The disadvantages of these well-known methods are the high cost of production equipment or the limited stability of the electrical resistance of the electrical contact.

Another limiting factor of known methods of electrical contacting on textile substrates is the size and toughness of the contact, which degrades the basic advantages of textile substrates - flexibility, weight and inertia towards the user. In order to obtain an electrically, mechanically and chemically stable electrical contact by the aforementioned methods, it is necessary to proceed to another step - encapsulating that protects the electrical connection from external influences, including the rigid electronic component itself protruding above the textile substrate.

According to Invention Application TW 2019 36 033 (A), electronic elements can be encapsulated on smart textiles using an injection moulding machine, or according to the invention in Invention Application US 2005 029 680 (A1) using the "globe top" technique. Another well-known invention from Invention Application EP 3 057 384 (A1) addresses encapsulation by means of flexible materials, in particular polyurethane coatings or films, and by means of subsequent closure between two layers of textile fabric.

A similar method is used in Application EP 3 784 007 (A1) where a component is encapsulated between a flexible substrate and a cover layer by thermo-compression which uses a connection layer comprising a thermoset material that melts and establishes the contact between the pads in the flexible substrate and the electrodes of the component.

Another method was published on the 2021 44TH INTERNATIONAL SPRING SEMINAR ON ELECTRONICS TECHNOLOGY (ISSE) under the title "Stretch Testing of SMD Resistors Contacted by a Novel Thermo-compression Method on a Textile Ribbon" where a SMD resistor is connected to the conductive thread of a textile ribbon and attached through thermo-compression and has a polymeric housing with a cavity for placing the SMD resistor where the plastic housing is melted and cooled under continuous pressure.

However, all these mentioned encapsulation methods require a number of technological steps, including the use of several machinery and mechanical fixtures, etc. Implementation of such electrical contact is then not only time-consuming but also financially demanding, which contradicts the easy possibility of implementing the given contact technologies into industry and spreading smart textiles to the general public.

With regard to the facts mentioned in the text above, there is a demand for a universal, affordable and operationally reliable method of electrically contacting and encapsulating conventional electronic components and electronic modules on textile substrates of smart textiles.

The task of the invention is to create a method of electrical contacting and encapsulation for surface mounting of electronic components on textile substrates of smart textiles, which would satisfy the above-mentioned demand for a universal, affordable and operationally reliable method, which would excel in reliability, mechanical and chemical resistance of the electrical contact as well as stable electrical resistance of the electrical contact, and which would not simultaneously require a complex manufacturing infrastructure, and which would also satisfy the requirements for high variability associated with an extensive range of electronic components intended for integration on textile substrates according to their functions. The invention should also include a housing which would allow the implementation of the invented method, and further an assembly consisting of a housing applied to a textile substrate which assembly would exhibit the claimed advantages of electrical interconnection and encapsulation of an electronic component according to the invention.

### Summary of the Invention

The task is solved by creating a method of electrically contacting and encapsulating an electronic component on a textile substrate, and by creating a housing and a hosing and textile substrate assembly according to the appended claims.

The summary of the invention is that, as part of Procedure Step (b), the housing is prepared from thermoplastic material, wherein the shape of its cavity for the embedded electronic component conforms to the shape of the electronic component. Simultaneously, the thermoplastic material of the housing in the area of the future electrical contact is supplemented by electrically conductive particles. The use of thermoplastic material combined with the replication of the electronic component's shape, allows thermocompression to be used to create an electrical contact and encapsulation. During thermocompression, the thermoplastic material temporarily decreases in viscosity when subjected to pressure and heat, enabling it to intermingle with the structure of the textile substrate. In addition, in the field of the electrical contact, the electrical conductivity is stabilized, apart from the precisely aligned contact of the electrical contact pad of the electronic component with the contact surface of the textile substrate, also by electrically conductive particles that surround the electrical contact during the less viscous phase of the thermoplastic material. This fortifies the reliability of the electrical contact, ensuring that it remains permanently embedded in the thermoplastic material once it re-solidifies.

It is also essential to the invention that Procedure Steps (e) and (f) are carried out simultaneously by means of thermocompression, which means that pressure and heat are applied from the outside of the housing to partially melt the housing into a less viscous state and then interlock it with the structure of the textile substrate. Afterwards, the heat ceases to be applied to the housing and textile substrate assembly while maintaining pressure, for the time necessary to re-solidify the housing. Once the housing is transformed into a solid body exhibiting mechanical resistance, it is possible to stop applying pressure.

The main benefit of the invention lies in its ability to consolidate a greater number of manufacturing steps into a smaller set, leading to enhanced economic viability, compared to other known methods of electrical contacting and encapsulating. At the same time, it is advantageous that despite the simplification of the manufacturing process, the electrical contacts prepared by the invention are resistant to external influences. The surface mounting carried out by the invention does not degrade the textile substrate and is substantially spontaneously inseparable. In addition, the invention guarantees stable electrical conductivity and thus stable electrical resistance of the electrical contact between the electrical contact pads of the electronic component.

In a developing embodiment of the invented method, the heated housing and textile substrate assembly is actively cooled to reduce the time required to re-solidify the viscous portion of the housing. Active cooling multiply reduces the dissipation time of the already excess heat from the housing and textile substrate assembly, which increases the production volume within the same time frame.

In another developing embodiment of the invented method, the housing is produced by means of additive manufacturing - 3D printing - as part of Procedure Step (b). Additive manufacturing enables the manufacture of a housing with a precise cavity shape to accommodate the embedded electronic component or electronic module. In addition, additive manufacturing enables to produce regions with modified material composition in the housing, simply by replacing one filament for 3D printing with another or by simultaneously printing from multiple filaments.

In the last developing embodiment of the invented method, as part of Procedure Step (c), the housing is printed directly to the electronic component. This is particularly beneficial in cases where the electronic component used is vulnerable and it is more preferable to encapsulate it immediately to avoid damage before applying it to a textile substrate. In addition, during the actual application process to the textile substrate, one step is omitted, which step involves placing the housing on the electronic component, thereby speeding up the production process again.

The invention also includes a housing for performing the invented method of electrically contacting and encapsulating an electronic component on a textile substrate for surface mounting of electronic components or electronic smart textile modules.

The object of the invention is that the housing consists of four parts made of thermoplastic material, the first part being a cavity for embedded component assembly with a rigid wall for inserting an electronic component. The cavity toughness primarily performs mechanic protection of the electronic component stored therein and inelastic fixation at the point of electrical contact of the component contact pads. The second part forms a flexible outer housing around the cavity for embedded component assembly to create an interface between the textile substrate and the rigid cavity with a gradient change in toughness. The gradient transition in material toughness prevents the creation of an interface with a step change in toughness at the foot of the outer flexible housing. If the transition between the textile substrate and the housing was a step, there would be a risk of excessive mechanical stress on the conductive fabric pattern and degradation of the smart textile function, but this completely compensates for the gradient transition in material toughness. At the same time, it is important that the shape of the cavity for embedded component assembly corresponds to the external shape of the electronic component. Furthermore, it is essential that the third part of the housing consists of an insert of electrical contact pads of the electronic component, wherein the insert consists of a thermoplastic material containing dispersed electrically conductive particles. The third part not only protects the electrical contact pads of the electronic component, but at the moment of realization of electrical contacting and encapsulating, it enters a less viscous state, thereby filling the space between the conductive surface and the contact pad of the component; and after subsequent solidification, promotes the electrical conductivity of the electrical contact and its stability. The last part of the housing is at least one thermoplastic material fixation underlay for insertion against the lower open side of the housing cavity for embedded component assembly for its closure and subsequent sealing by thermocompression.

The housing according to the invention excels in simple application, simultaneously excellent results in tests of mechanical stress and resistance to external influences such as dust, humidity, adverse mechanical effects, etc.

In a developing embodiment of the housing invention, the fixation underlay has at least one opening filled with an insert of electrical contact pads of an electronic component. This is particularly important in applications where the textile substrate is not located between the bottom part of the open cavity and the fixation underlay but where the textile substrate is located under the fixation underlay.

Preferably, the fixation underlay exhibits two zones, where the first zone is rigid and serves to close the open wall of the cavity for embedded component assembly. Therefore, the shape of the first zone follows the shape of the open wall of the cavity for embedded component assembly. The second zone of the fixation underlay is flexible and wraps the first zone, which is rigid. The design of the fixation underlay allows to seal the cavity for embedded component assembly, which has all its sides rigid, and at the same time the flexible part is linked by thermocompression and subsequent cooling with the structure of the textile substrate.

Furthermore, it is preferred if the flexible housing has at least one alignment pin on the underside and the fixation underlay has at least one alignment hole. The alignment pin can only fit into the alignment hole, ensuring that the fixation underlay fits exactly against the remaining parts of the housing.

The last component of the invention is an assembly consisting of a housing and a textile substrate. The object of the invention is that the adhesion between the housing and the textile substrate consists of all parts of the solidified thermoplastic material of the housing, namely the rigid cavity, flexible housing and fixation underlay, in the structure of the textile substrate. This connection is completely impermeable and durable, making the assembly an ideal solution for smart textiles requiring surface mounting of electronic components - SMD electronic elements.

Thanks to the invention, there is no need to separate electronic components and modules from smart garments using external housings, housings and cables, thereby affecting both the user's comfort and the overall weight and flexibility of the garment.

From the point of view of the production of smart textiles, the main benefits of the invention include the simplification of the production process in which the process steps are carried out simultaneously, its friendliness to textile substrates, since textile substrates are resistant to pressure and at the same time have a much higher material degradation temperature than the melting point of thermoplastic material materials of the housing, and the simplicity of the production process, which is suitable for automation. In terms of applications, the main benefits of the invention include the resistance of the encapsulation to external influences, both mechanical and chemical, and the quality of the electrical contact, which exhibits stable electrical properties even during extreme stresses, such as exposure to routine repeated maintenance (automatic washing and drying), wearing smart textiles in emergency situations, e.g. when performing interventions by integrated rescue services, etc.

### Explanation of Drawings

The said invention will be explained in more detail in the following illustrations, wherein:
- Fig. 1: illustrates the components of the assembly prior to thermocompression with a housing variant for the electronic component and a textile substrate arranged between the fixation underlay and the remaining part of the housing, wherein all parts of the housing were printed prior to insertion of the electronic component;
- Fig. 2: illustrates the components of the assembly prior to thermocompression with a housing variant for the electronic module and a textile substrate arranged between the fixation underlay and the remaining part of the housing, wherein all parts of the housing were printed prior to insertion of the electronic component;
- Fig. 3: illustrates the components of the assembly prior to thermocompression with a housing variant for the electronic component and with a textile substrate arranged between the fixation underlay and the remaining part of the housing, wherein the insert of the electrical contact pads was printed after insertion of the electronic component,
- Fig. 4: illustrates the components of the assembly prior to thermocompression with a housing variant for the electronic module and with a textile substrate arranged between the fixation underlay and the remaining part of the housing, wherein the insert of the electrical contact pads was printed after insertion of the electronic component,
- Fig. 5: illustrates components of an assembly prior to thermocompression with a housing variant for an electronic component having two fixation underlays to form a sandwich structure with a textile substrate,
- Fig. 6: illustrates components of an assembly prior to thermocompression with a housing variant for an electronic module having two fixation underlays to form a sandwich structure with a textile substrate,
- Fig. 7: illustrates components of an assembly prior to thermocompression with a housing variant for an electronic component having a single fixation underlay adapted to attach a textile substrate from the bottom thereof,
- Fig. 8: illustrates components of an assembly prior to thermocompression with a housing variant for an electronic module having a single fixation underlay adapted to attach a textile substrate from the bottom thereof.

### Examples of Invention Embodiments

It is understood that the specific examples of embodiments of the invention described and illustrated below are presented for illustrative purposes and not as a restriction of the invention to those examples. Persons skilled in the art will find or be able to provide, using routine experimentation, a greater or lesser number of equivalents to the specific embodiments of the invention described herein.

The term "smart textile" means a garment that, in addition to its clothing function, has an additional function, based on electronic equipment. Examples of such smart textiles include athletes' training overalls with electronic monitoring of the athlete's body, as well as firefighters' emergency suits with electronic monitoring of the environment or monitoring of the firefighters themselves for increased safety, further for example overalls for "motion capture" film technology, racers' jerseys, workwear, etc. The smart textiles expert will be able to list a number of other examples falling under the set with the common name "smart textiles".

To make a smart textile functional, it is made of a textile substrate 2, which includes, for example, fully integrated sensors for temperature, humidity, pressure, bending, etc. Integration is based on making an electrically conductive motif with suitable topology directly in the structure of the textile substrate 2, for example by means of conductive or resistive conductive textile thread, or yarn, or by applying conductive paste and ink. Similarly, electrically conductive tracks 11 are made in the textile substrate 2.

A layman can imagine a smart garment as an electrical circuit of a printed circuit board, where the supporting circuit board is a textile substrate 2, and the connection between the electronic components 1 is realized, for example, by embroidered electrically conductive tracks 11, wherein the electronic components 1 intended for surface mounting are not fixed on a rigid substrate as is the case on the printed circuit board, but directly on the textile substrate 2.

Therefore, on the textile substrate 2, there are specially embroidered alignment marks made of a non-conductive thread to facilitate the surface assembly of electronic components 1. Alignment marks will help with precise positioning of the electronic component 1 so that its electrical contact pads 7 correctly fit the designated electrically conductive tracks 11 of the textile substrate 2. Since conductive tracks 11 are usually small in size, contact surfaces are embroidered on the textile substrate 2.

The technical character of the electronic component 1 comprises both electronic components which are not integrated into the textile substrate 2 and more complex electronic modules which are used for surface mounting on the textile substrate 2.

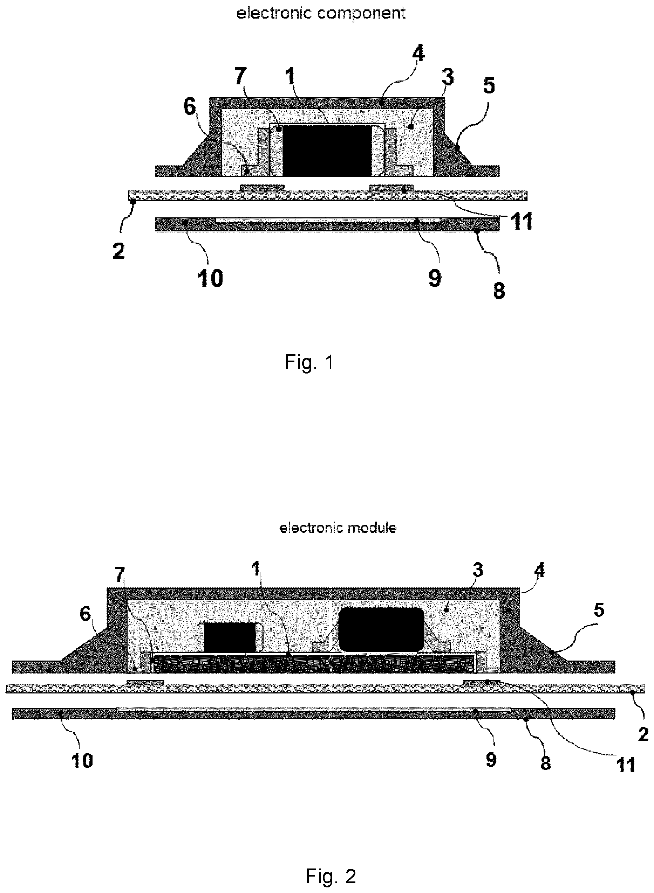

Fig. 1 shows the components of the future assembly before the thermocompression process. The components include an electronic component 1, e.g. an electronic component for transmitting a radio signal for wireless data transmission, to be surface mounted on a textile substrate 2.

Furthermore, Fig. 1 shows that the contact surfaces of electrically conductive tracks 11 are available on the face side of the textile substrate 2. Electrical contact pads 7 protrude from the electronic component 1.

Another part of the future assembly is a housing which consists of a cavity 3 for embedded component assembly, the internal shape of which exactly copies the electronic component 1, and which consists of a rigid thermoplastic material (e.g. ABS-T, ASA, PC, PC/PMMA, PET-G, PC/ABS, PP, CPE - Hardness > 60 Shore D) to form a rigid protection of the electronic component 1. The cavity 3 for embedded component assembly is surrounded by a flexible housing 4 which, through a gradient transition 5 in material toughness around the periphery of the cavity 3 for embedded component assembly, forms a flexible ring whose task is to fit well against the face side of the textile substrate 2 and ensure a smooth transition between the textile substrate and the rigid cavity. The figure shows that the gradient transition 5 in material toughness is realized by gradually changing the thickness of the flexible housing 4. The flexible housing 4 is also made of thermoplastic material (e.g. based on polyurethane (TPU), polyester (TPE) or styrene (TPS) - hardness < 75 Shore A). The housing includes an insert 6 for surrounding electrical contact pads 7. The insert 6 is printed from a thermoplastic material containing electrically conductive particles (e.g. polyester-based material containing copper particles). Electrically conductive particles can be produced from various electrically conductive materials, e.g. (metals, carbon, carbon allotropes, conductive metal oxides), wherein the term particles can also be understood as balls, fibers, flakes, nanowires, nanoparticles or nanotubes. The last part of the housing is a fixation underlay 8, which serves to close the cavity 3 for embedded component assembly, thereby sealing the housing, including its adherence to the textile substrate 2 from the reverse side of the textile substrate 2. The fixation underlay 8 combines both flexible and rigid thermoplastic materials. The first zone 9 of the fixation underlay 8 is made of rigid thermoplastic material, similar to the cavity 3 for embedded component assembly. The first zone 9 corresponds in shape and size to the open side of the cavity through which the electronic component 1 was inserted into the cavity 3 for embedded component assembly. The second zone 10 is made of flexible thermoplastic material, like the flexible housing 4, wherein is surrounds the first zone 9, and performs the same function as the flexible housing 4, except from the reverse side of the textile substrate 2.

Fig. 2 presents a similar embodiment of the invention, except that the electronic component 1 consists of an electronic module which is more complicated in design than the electronic component 1.

Surface mounting and encapsulation of the electronic component 1 on the textile substrate 2 took place by 3D printing of a tailor-made housing for the electronic component 1, after which the electronic component 1 was inserted. The housing without the fixation underlay 8 was placed on the face side of the textile substrate 2 with precise seating according to the alignment marks, while the fixation underlay 8 was placed on the reverse side of the textile substrate 2 to close the cavity 3 for embedded component assembly with the textile substrate 2 encapsulated inside.

3D printing of the housing can be executed gradually, so that parts are printed according to the currently used filament (thermoplastic material), or the 3D printer is provided with multiple filaments simultaneously and a filament is distributed to the print head according to the currently printed part of the housing, or the 3D printer is provided with multiple print heads that are used according to the current printed part of the housing.

Subsequently, a thermocompression device was used, which began to apply increased pressure and heat to the housing. The pressure must be increased to allow the heat-melted parts of the housing to penetrate the textile substrate 2 structure and to connect the electrical conductive track 11 and the electrical contact pads 7. At the same time, the insert 6 is melted by heat, the electrically conductive particles of which adhere to both the electrical contact pads 7 and the electrically conductive tracks 11. The heating temperature exceeds the melting point of the thermoplastic material housing material, but is lower than the degradation temperature of the textile substrate 2 and the electronic component 1.

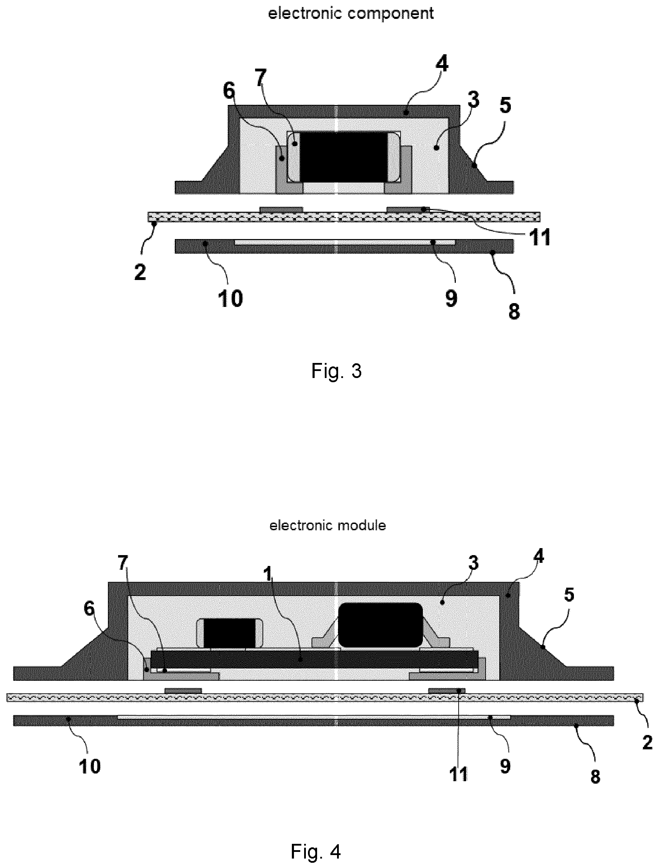

After connecting the thermoplastic material of the housing with the structure of the textile substrate 2, the increased pressure is maintained, but the heat distribution is interrupted to return the thermoplastic material of the housing to the solid state. The heat dissipation process can be accelerated if the thermocompression device in the pressure jaws includes a cooling circuit in addition to the heating circuit, or by separating the melting and cooling processes using two different temperature presses
Fig. 3 and Fig. 4 show housings similar to those of Figs. 1 and 2 but printed directly onto the surface of electronic components 1. In particular, the insert 6 housing part was printed directly onto the electrical contact pads 7 of electronic components 1.

With regard to the actual application of the invention to the textile substrate 2, this is similar to the implementation of the invention in Figures 1 and 2.

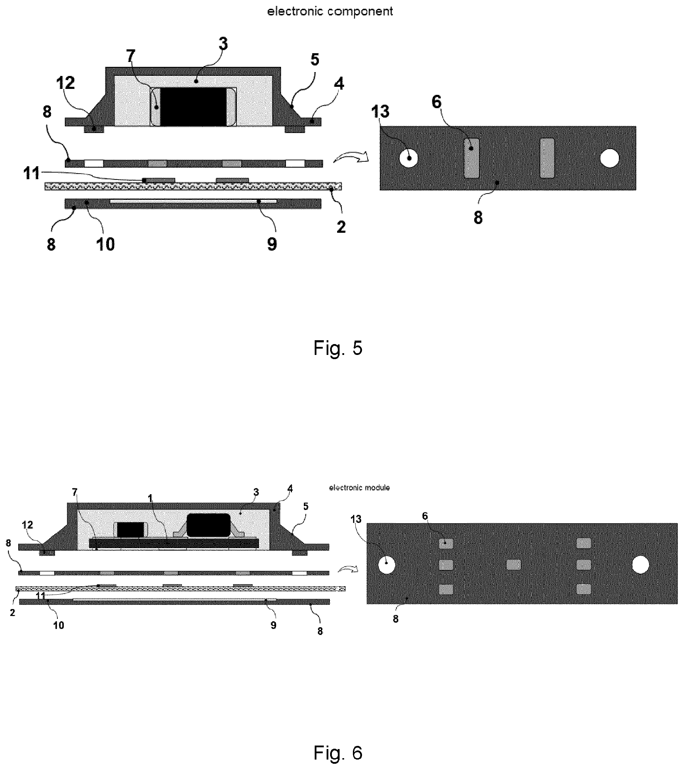

In Figs. 5 and 6, the implementation of the invention of Figs. 1 and 2 is improved by the technical features of an alignment pin 12 and an alignment hole 13, wherein the fixation underlay 8 is made of two parts. The first part of the fixation underlay 8 is attached to the face side of the textile substrate 2 and its task is to close the cavity 3 for embedded component assembly and attach the inserts 6 to the electrical contact pads 7. Inserts 6 are in the holes of the first part of the fixation underlay 8. This is particularly advantageous for electrical contact pads of electronic components 1 that do not allow the insert 6 to be applied directly in the cavity 3 area for embedded component assembly. The second part of the fixation underlay 8 is attached to the reverse side of the textile substrate 2. Its task is additional mechanical support and additional sealing of electrical contacts from the reverse side of the textile substrate 2.

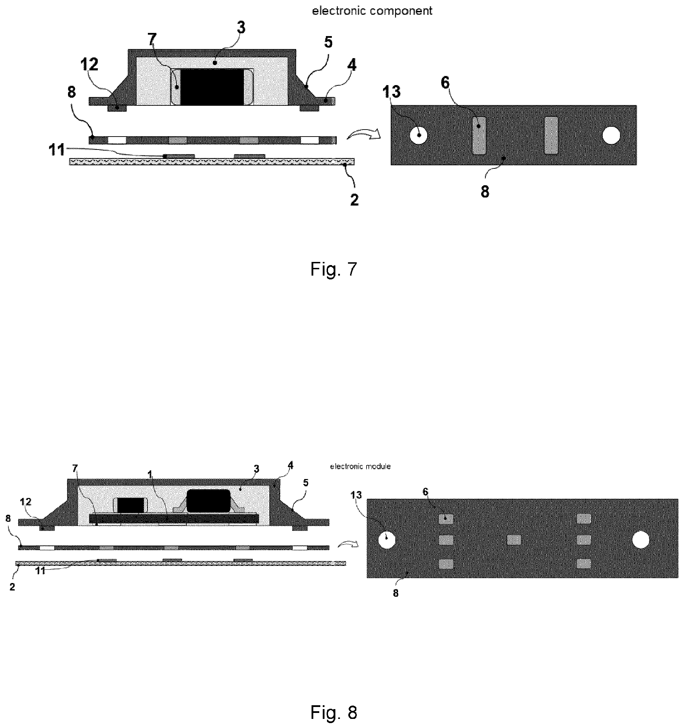

Fig. 7 and 8 present an alternative to the embodiment of the invention of Figs. 5 and 6, but without the two-piece fixation underlay 8. The fixation underlay 8 shows only one part which is attached to the face side of the textile substrate 2. The precise connection of the fixation underlay 8 to the cavity 3 for embedded component assembly is again solved by the present alignment pins 12 and alignment holes 13.

### Industrial Applicability

A method of electrically contacting and encapsulating an electronic component on a textile substrate of a smart textile, a housing for carrying out the invented method, and a housing and textile substrate assembly according to the invention find use in the manufacture of smart textiles.

### Reference Signs List

- 1: electronic component
- 2: textile substrate
- 3: cavity for embedded component assembly
- 4: flexible housing
- 5: gradient transition in material toughness
- 6: electrical conductive insert
- 7: electrical component's contact pads
- 8: fixation underlay
- 9: first zone of fixation underlay
- 10: second zone of fixation underlay
- 11: electrical conductive track integrated into textile substrate
- 12: alignment pin
- 13: alignment hole

## Claims

1. Method of electrically contacting and encapsulating an electronic component (1) on a textile substrate (2) for surface-mounting of electronic components or electronic modules in smart textiles, including creating electrical connections with electrically conductive tracks (11) of the textile substrate (2) consisting of procedure steps: (a) alignment marks are formed on the textile substrate (2), (b) a housing (4) with a cavity for embedded component placement is prepared for encapsulating the electronic component (1), (c) the housing and the electronic component (1) are assembled together, (d) the electronic component (1) is aligned with the textile substrate (2) according to the alignment marks, (e) electrical contact is formed between the electrically conductive tracks (11) of the textile substrate (2) and the electronic component (1), (f) the housing is sealed for encapsulating electrical contact and fixing the surface-mounting of the electronic component (1) on the textile substrate (2), and that procedure steps (e) and (f) are carried out simultaneously by means of thermocompression, wherein pressure and heat partially melt the housing into a less viscous state and subsequently become interconnected with the structure of the textile substrate (2), whereupon the heat ceases to act on the housing and the textile substrate (2) while maintaining the pressure to enable thermoplastic material re-solidification, and after then the pressure ceases to act as well, wherein as part of procedure step (b), the housing is prepared from thermoplastic material, wherein housing consists of four parts of thermoplastic material, where the first part being the cavity (3) for embedded component assembly of the housing with a rigid wall for inserting the electronic component (1) and protecting it from external influences, wherein the inner shape of the cavity (3) for embedded component assembly corresponds to the outer shape of the electronic component (1), the second part of the housing being a flexible housing (4) formed around the rigid wall of the cavity (3) for embedded component assembly for connecting the housing to the textile substrate (2) by means of thermocompression, and at the same time the interface between the cavity (3) for embedded component assembly and the flexible housing (4) is formed by a gradient transition (5) in material toughness, furthermore that the third part of the housing consists of an insert (6) of electrical contact pads (7) of the electronic component (1), the insert (6) being formed of a thermoplastic material containing dispersed electrically conductive particles, and further that the fourth part of the housing is at least one fixation underlay (8) of thermoplastic material for closing the cavity (3) for embedded component assembly.

2. The method according to claim 1 wherein the heated assembly of the housing and the textile substrate (2) is actively cooled after the housing is interlinked with the textile substrate (2) to reduce the time required for the thermoplastic material to re-solidify.

3. The method according to claim 1 or 2 wherein the housing as part of procedure step (b) is manufactured by means of additive manufacturing - 3D printing.

4. The method according to claim 3 wherein the housing as part of procedure step (c) is printed directly onto the surface of the electronic component (1).

5. A housing for performing a method of electrically contacting and encapsulating an electronic component (1) on a textile substrate (2) for surface mounting of electronic components or electronic modules of smart textiles according to any one of claims 1 to 4 wherein the housing consists of four parts of thermoplastic material, where the first part being a cavity (3) for embedded component assembly of the housing with a rigid wall for inserting the electronic component (1) and protecting it from external influences, wherein the inner shape of the cavity (3) for embedded component assembly corresponds to the outer shape of the electronic component (1), the second part of the housing being a flexible housing (4) formed around the rigid wall of the cavity (3) for embedded component assembly for connecting the housing to the textile substrate (2) by means of thermocompression, and at the same time the interface between the cavity (3) for embedded component assembly and the flexible housing (4) is formed by a gradient transition (5) in material toughness, furthermore that the third part of the housing consists of an insert (6) of electrical contact pads (7) of the electronic component (1), the insert (6) being formed of a thermoplastic material containing dispersed electrically conductive particles, and further that the fourth part of the housing is at least one fixation underlay (8) of thermoplastic material for closing the cavity (3) for embedded component assembly.

6. A housing according to claim 5 wherein the fixation underlay (8) has at least one opening filled with an insert (6) of electrical contact pads (7) of an electronic component (1).

7. A housing according to claim 5 or 6 wherein the fixation underlay (8) has two zones where the first (9) zone is rigid and its shape corresponds to the shape of the open side of the cavity (3) for embedded component assembly for closing the cavity (3) for embedded component assembly, and the second zone (10) is flexible, wherein it surrounds the first zone (9).

8. A housing according to any one of claims 5 to 7 wherein the flexible housing (4) has at least one alignment pin (12) on the attaching side facing the textile substrate (2) and the fixing underlay (8) has at least one alignment hole (13).

9. An assembly of a housing formed according to any one of claims 5 to 8 and a textile substrate (2) of a smart textile wherein the joint of the housing and the textile substrate (2) consists of a portion of the thermoplastic material of the flexible housing (4) and a fixation underlay (8) leaked and solidified in the structure of the textile substrate (2).

## Patentansprüche

1. Verfahren zur elektrischen Kontaktierung und Verkapselung eines elektronischen Bauteils (1) auf einem Textilsubstrat (2) zur Oberflächenmontage von elektronischen Bauteilen oder elektronischen Modulen in intelligenten Textilien, einschließlich der Herstellung von elektrische Verbindungen mit elektrisch leitfähigen Bahnen (11) des Textilsubstrats (2), bestehend aus Verfahrensschritten: (a) Ausrichtmarken werden auf dem Textilsubstrat (2) ausgebildet, (b) ein Gehäuse (4) mit einem Hohlraum zur Einbettung des elektronischen Bauteils wird zum Verkapseln des elektronischen Bauteils (1) vorbereitet, (c) das Gehäuse und das elektronische Bauteil (1) werden zusammengefügt, (d) das elektronische Bauteil (1) wird gemäß den Ausrichtmarken mit dem Textilsubstrat (2) ausgerichtet, (e) elektrischer Kontakt wird zwischen den elektrisch leitfähigen Bahnen (11) dem Textilsubstrat (2) und dem elektronischen Bauteil (1) hergestellt, (f) das Gehäuse wird zum Verkapseln des elektrischen Kontakts und zum Fixieren der Oberflächenmontage des elektronischen Bauteils (1) auf dem Textilsubstrat (2) abgedichtet, und dass die Verfahrensschritte (e) und (f) gleichzeitig mittels Thermokompression durchgeführt werden, wobei Druck und Wärme das Gehäuse teilweise in einen weniger viskosen Zustand schmelzen und sich anschließend mit der Struktur des Textilsubstrats (2) verbinden, woraufhin die Wärme unter Aufrechterhaltung des Drucks auf das Gehäuse und das Textilsubstrat (2) unter Aufrechterhaltung des Drucks zur Aktivierung der Wiedererstarrung des thermoplastischen Materials, und danach auch der Druck aufhört zu wirken, **wobei** im Rahmen des Verfahrensschritts (b) das Gehäuse aus thermoplastischem Material vorbereitet wird, wobei das Gehäuse aus vier Teilen aus thermoplastischem Material besteht, wobei der erste Teil der Hohlraum (3) zur Einbettung der Bauteilgruppe des Gehäuses mit einer starren Wand zum Einsetzen des elektronischen Bauteils (1) ist und es vor äußeren Einflüssen schützt, wobei die innere Form des Hohlraums (3) für die eingebettete Bauteilgruppe der äußeren Form des elektronischen Bauteils (1) entspricht, wobei der zweite Teil des Gehäuses ein flexibles Gehäuse (4) ist, das um die starre Wand des Hohlraums (3) für die eingebettete Bauteilgruppe geformt ist und das Gehäuse mittels Thermokompression mit dem Textilsubstrat (2) verbindet, und gleichzeitig die Schnittstelle zwischen dem Hohlraum (3) für die eingebettete Bauteilgruppe und dem flexiblen Gehäuse (4) durch einen Gradientenübergang (5) in der Materialzähigkeit gebildet wird, ferner der dritte Teil des Gehäuses aus einem Einsatz (6) aus elektrischen Kontaktflächen (7) des elektronischen Bauteils (1) besteht, wobei der Einsatz (6) aus einem thermoplastischen Material besteht, das dispergierte elektrisch leitfähige Partikel enthält, und ferner der vierte Teil des Gehäuses aus mindestens einer Fixierunterlage (8) aus thermoplastischem Material zum Verschließen des Hohlraums (3) für die eingebettete Bauteilgruppe besteht.

2. Verfahren nach Anspruch 1, **wobei** die beheizte Baugruppe aus Gehäuse und Textilsubstrat (2) nach dem Verbinden des Gehäuses mit dem Textilsubstrat (2) aktiv gekühlt wird, um die Zeit für das Wiedererstarren des thermoplastischen Materials zu reduzieren.

3. Verfahren nach Anspruch 1 oder 2, **wobei** das Gehäuse im Rahmen des Verfahrensschrittes (b) mittels additiver Fertigung - 3D-Druck - hergestellt wird.

4. Verfahren nach Anspruch 3, **wobei** das Gehäuse im Rahmen des Verfahrensschritts (c) direkt auf die Oberfläche des elektronischen Bauteils (1) aufgedruckt wird.

5. Gehäuse zur Durchführung eines Verfahrens zur elektrischen Kontaktierung und Kapselung eines elektronischen Bauteils (1) auf einem Textilsubstrat (2) zur Oberflächenmontage von elektronischen Bauteilen oder elektronischen Modulen intelligenter Textilien nach einem der Ansprüche 1 bis 4, **wobei** das Gehäuse aus vier Teilen aus thermoplastischem Material besteht, wobei der erste Teil ein Hohlraum (3) für die eingebettete Bauteilgruppe des Gehäuses mit einer starren Wand zum Einsetzen des elektronischen Bauteils (1) und zum Schutz vor äußeren Einflüssen ist, wobei die innere Form des Hohlraums (3) für die eingebettete Bauteilgruppe der äußeren Form des elektronischen Bauteils (1) entspricht, wobei der zweite Teil des Gehäuses ein flexibles Gehäuse (4) ist, das um die starre Wand des Hohlraums (3) für die eingebettete Bauteilgruppe gebildet ist, um das Gehäuse mit dem Textilsubstrat (2) mittels Thermokompression zu verbinden, und gleichzeitig die Schnittstelle zwischen dem Hohlraum (3) für die eingebettete Bauteilgruppe und dem flexiblen Gehäuse (4) durch einen Gradientenübergang (5) in Materialzähigkeit gebildet ist, ferner dass der dritte Teil des Gehäuses aus einem Einsatz (6) von elektrischen Kontaktflächen (7) des elektronischen Bauteils (1) besteht, wobei der Einsatz (6) aus einem thermoplastischen Material gebildet ist, das dispergierte elektrisch leitfähige Partikel enthält, und ferner, dass der vierte Teil des Gehäuses mindestens eine Fixierunterlage (8) aus thermoplastischem Material zum Verschließen des Hohlraums (3) für die eingebettete Bauteilgruppe ist.

6. Gehäuse nach Anspruch 5, **wobei** die Fixierunterlage (8) mindestens eine Öffnung aufweist, die mit einem Einsatz (6) elektrischer Kontaktflächen (7) eines elektronischen Bauteils (1) gefüllt ist.

7. Gehäuse nach Anspruch 5 oder 6, **wobei** die Fixierunterlage (8) zwei Zonen aufweist, wobei die erste (9) Zone starr ist und ihre Form der Form der offenen Seite des Hohlraums (3) für die eingebettete Bauteilgruppe zum Verschließen des Hohlraums (3) für die eingebettete Bauteilgruppe entspricht, und die zweite Zone (10) flexibel ist, wobei sie die erste Zone (9) umgibt.

8. Gehäuse nach einem der Ansprüche 5 bis 7, **wobei** das flexible Gehäuse (4) auf der dem Textilsubstrat (2) zugewandten Befestigungsseite mindestens einen Ausrichtungsstift (12) und die Fixierunterlage (8) mindestens ein Ausrichtungsloch (13) aufweist.

9. Baugruppe eines Gehäuses, gebildet nach einem der Ansprüche 5 bis 8, und eines Textilsubstrats (2) aus einem intelligenten Textil, **wobei** die Verbindung des Gehäuses und des Textilsubstrats (2) aus einem Abschnitt des thermoplastischen Materials des flexiblen Gehäuses (4) und einer Fixierunterlage (8) besteht, das in die Struktur des Textilsubstrats (2) ausgetreten und erstarrt ist.

## Revendications

1. Procédé de contact électrique et d'encapsulation d'un composant électronique (1) sur un substrat textile (2) pour le montage en surface de composants électroniques ou de modules électroniques dans des textiles intelligents, y compris la création de connexions électriques avec des pistes électriquement conductrices (11) du substrat textile (2), comprenant les étapes de la procédure: (a) des marques d'alignement sont formées sur le substrat textile (2), (b) un boîtier (4) avec une cavité pour la mise en place d'un composant encastré est préparé pour l'encapsulation du composant électronique (1), (c) le boîtier et le composant électronique (1) sont assemblés ensemble, (d) le composant électronique (1) est aligné avec le substrat textile (2) selon les marques d'alignement, (e) un contact électrique est formé entre les pistes électriquement conductrices (11) le substrat textile (2) et le composant électronique (1), (f) le boîtier est scellé pour l'encapsulation du contact électrique et la fixation du montage en surface du composant électronique (1) sur le substrat textile (2), et que les étapes de la procédure (e) et (f) sont réalisées simultanément par thermocompression, où la pression et la chaleur font fondre partiellement le boîtier jusqu'à un état de viscosité réduite et devenant ensuite interconnecté avec la structure du substrat textile (2), après quoi la chaleur cesse d'agir sur le boîtier et le substrat textile (2), tandis que la pression est maintenue afin de permettre la re-solidification du matériau thermoplastique, puis la pression cesse également d'agir, où, dans le cadre de l'étape de procédure (b), le boîtier est préparé en matériau thermoplastique, où le boîtier est constitué de quatre parties en matériau thermoplastique, la première partie étant la cavité (3) pour l'assemblage du composant encastré du boîtier avec une paroi rigide pour insérer le composant électronique (1) et le protéger des influences extérieures, où la forme intérieure de la cavité (3) pour l'assemblage du composant encastré correspond à la forme extérieure du composant électronique (1), la deuxième partie du boîtier étant un boîtier flexible (4) formé autour de la paroi rigide de la cavité (3) pour l'assemblage du composant encastré pour relier le boîtier au substrat textile (2) par thermocompression, et dans le même temps l'interface entre la cavité (3) pour l'assemblage du composant encastré et le boîtier flexible (4) est formée par une transition graduelle (5) de la résistance du matériau, et en outre, la troisième partie du boîtier consiste en un insert (6) de zones de contact électriques (7) du composant électronique (1), l'insert (6) étant formé en matériau thermoplastique contenant des particules électriquement conductrices dispersées, et la quatrième partie du boîtier comprend au moins un sous-couche de fixation (8) en matériau thermoplastique pour fermer la cavité (3) pour l'assemblage du composant encastré.

2. Procédé selon la revendication 1, **où** l'ensemble chauffé du boîtier et du substrat textile (2) est refroidi activement après la liaison du boîtier avec le substrat textile (2) pour réduire le temps nécessaire à la resolidification du matériau thermoplastique.

3. Procédé selon la revendication 1 ou 2, **où** le boîtier, dans le cadre de l'étape (b) de procédure, est fabriqué au moyen de la fabrication additive - impression 3D.

4. Procédé selon la revendication 3, **où** l'impression du boîtier dans le cadre de l'étape (c) de procédure est réalisée directement sur la surface du composant électronique (1).

5. Boîtier pour la mise en œuvre d'un procédé de contact électrique et d'encapsulation du composant électronique (1) sur un substrat textile (2) pour montage en surface du composant électronique ou de modules électroniques de textiles intelligents selon l'une quelconque des revendications 1 à 4, **où** le boîtier est constitué de quatre parties en matériau thermoplastique, la première partie étant une cavité (3) pour l'assemblage du composant encastré du boîtier avec une paroi rigide pour insérer le composant électronique (1) et le protéger des influences extérieures, où la forme intérieure de la cavité (3) pour l'assemblage du composant encastré correspond à la forme extérieure du composant électronique (1), la deuxième partie du boîtier étant un boîtier flexible (4) formé autour de la paroi rigide de la cavité (3) pour l'assemblage du composant encastré pour relier le boîtier au substrat textile (2) par thermocompression, et en ce que l'interface entre la cavité (3) pour l'assemblage du composant encastré et le boîtier flexible (4) est formée par une transition de gradient (5) de résistance du matériau, en outre que la troisième partie du boîtier est constituée d'un insert (6) de zones de contact électrique (7) du composant électronique (1), l'insert (6) étant formé d'un matériau thermoplastique contenant des particules dispersées électriquement conductrices, et en outre que la quatrième partie du boîtier est au moins une sous-couche de fixation (8) en matériau thermoplastique pour fermer la cavité (3) pour l'assemblage du composant encastré.

6. Boîtier selon la revendication 5, **où** la sous-couche de fixation (8) présente au moins une ouverture remplie d'un insert (6) de zones de contact électrique (7) du composant électronique (1).

7. Boîtier selon la revendication 5 ou 6, où la sous-couche de fixation (8) présente deux zones **où** la première (9) zone est rigide et sa forme correspond à la forme du côté ouvert de la cavité (3) pour l'assemblage du composant encastré pour la fermeture de la cavité (3) pour l'assemblage du composant encastrés, et la deuxième zone (10) est flexible, où elle entoure la première zone (9).

8. Boîtier selon l'une quelconque des revendications 5 à 7, **où** le boîtier souple (4) comporte au moins une goupille d'alignement (12) sur le côté de fixation faisant face au substrat textile (2), la sous-couche de fixation (8) comporte au moins un trou d'alignement (13).

9. Assemblage d'un boîtier formé selon l'une quelconque des revendications 5 à 8 et d'un substrat textile (2) d'un textile intelligent, **où** la jonction entre le boîtier et le substrat textile (2) est constituée d'une portion du matériau thermoplastique du boîtier flexible (4) et d'une sous-couche de fixation (8) ayant pénétré puis étant solidifiée dans la structure du substrat textile (2).
